# EUROPEAN PATENT SPECIFICATION

(11) **EP 3 400 610 B1**
(45) Date of publication and mention of the grant of the patent: **21.09.2022**
(21) Application number: 16840363.2
(22) Date of filing: 30.09.2016
(51) Int. Cl.: H01L 27/12, H01L 21/77, G06F 3/041, G06F 3/044

(54) **DISPLAY SUBSTRATE, FABRICATION METHOD FOR FORMING THE SAME, AND DISPLAY DEVICE CONTAINING THE SAME**
ANZEIGESUBSTRAT, HERSTELLUNGSVERFAHREN ZUR HERSTELLUNG DAVON UND ANZEIGEVORRICHTUNG DAMIT
SUBSTRAT D'AFFICHAGE, PROCÉDÉ DE FABRICATION POUR SA FORMATION, ET DISPOSITIF D'AFFICHAGE LE CONTENANT

(30) Priority: 04.01.2016 CN 201610006872
(43) Date of publication of application: 14.11.2018
(73) Proprietor: BOE Technology Group Co., Ltd., Beijing 100015 (CN); Beijing BOE Display Technology Co., Ltd., Beijing 100176 (CN)
(72) Inventor: SANG, Qi, Beijing 100176 (CN); WANG, Baoqiang, Beijing 100176 (CN); PARK, Sangjin, Beijing 100176 (CN)
(74) Representative: Cohausz & Florack
(86) International application number: PCT/CN2016/101075
(87) International publication number: WO 2017/118123

(56) References cited:
- WO-A1-2015/010421
- WO-A1-2015/088629
- CN-A- 104 464 603
- CN-A- 104 716 144
- CN-A- 104 716 144
- CN-A- 104 750 307
- CN-A- 105 575 977
- CN-U- 202 887 154
- CN-U- 205 264 704
- US-A1- 2014 043 306
- US-A1- 2014 375 922
- US-A1- 2015 185 929
- US-A1- 2015 268 759

## Description

### CROSS-REFERENCE TO RELATED APPLICATION

This application claims priority to Chinese Patent Application No. 201610006872.8, filed January 4, 2016.

### TECHNICAL FIELD

The present invention relates to display technology, more particularly, to a display substrate, a fabrication method for forming the display substrate, and a display device containing the display substrate.

### BACKGROUND

As technology advances, liquid crystal displays (LCDs), organic light-emitting diode (OLED) displays, and other high-tech displays have been widely used in display devices such as laptop computers, smart phones, and televisions. In-cell touch technology provides one-stop service and becomes a solution to implement display functions with touch functions. By using in-cell technology, touch panels can be integrated with LCDs. In-cell technology has high integration level, low power consumption, high display quality, and multiple touch points. In-cell technology also makes the display device thin and light, and low in cost. Because of these advantages, in-cell technology has become a trench in display technology.

International patent application WO 2015/088629 A1 discloses a self-capacitive touch sensor panel configured to have a portion of both the touch and display functionality integrated into a common layer is provided. The touch sensor panel includes a layer with circuit elements that can switchably operate as both touch circuitry and display circuitry such that during a touch mode of the device the circuit elements operate as touch circuitry and during a display mode of the device the circuit elements operate as display circuitry. The touch mode and display mode can be time multiplexed.

US patent application US 2015/268759 A1 discloses a processing system for a display device comprising an integrated capacitive sensing device that includes at least one input/output pad that is selectable between providing source signals to the display device and operating a sensor electrode for capacitive sensing.

International patent application WO 2015/010421 A1 discloses an array substrate, the array substrate comprising: a plurality of sub-pixel units arranged in the form of a matrix, a plurality of touch drive electrodes and a plurality of touch sensing electrodes; every two rows of adjacent sub-pixel units form a sub-pixel unit group, and two grid lines, which provide grid signals for the two rows of sub-pixel units respectively, are arranged between the two rows of sub-pixel units; the touch drive electrodes are located among the sub-pixel unit groups on the array substrate and distributed along the row direction of the sub-pixel units; and the touch sensing electrodes are located on the array substrate, distributed along the column direction of the sub-pixel units, and insulated from the touch drive electrodes and the grid lines. Chinese patent application CN 104716144 A discloses an array substrate, a fabricating method thereof and a display device, the fabricating method comprises forming a plurality of touch electrodes on a base substrate, a plurality of touch electrode leads for leading out signals of the touch electrodes and an array structure comprising a plurality of conducting structures. At least part of touch electrode leads and at least one of the conducting structures are disposed in a same layer and made from a same material. The fabricating method can reduce the amount of masks used in the fabricating process of the array substrate.

### SUMMARY

In one aspect, the present invention provides a display substrate, including: a plurality of gate lines, a plurality of data lines, a plurality of gate lead wires, and a plurality of touch electrode lead wires, the plurality of gate lead wires and the plurality of touch electrode lead wires form a one-to-one correspondence, the plurality of gate lead wires being connected to a gate integrated circuit (IC) and the plurality of touch electrode lead wires being connected to a touch IC, each one of the plurality of gate lead wires configured for providing a gate signal to at least one of the plurality of gate lines, at least one of the plurality of touch electrode lead wires configured for transmitting a touch signal to a touch electrode, wherein:
at least one of the plurality of gate lead wires and at least one of the plurality of touch electrode lead wires are aligned along a direction that one of the plurality of data lines is aligned, wherein the end of the at least one of the plurality of touch electrode lead wires and the end of the at least one of the plurality of gate lead wires are facing each other,
the at least one of the plurality of gate lead wires is connected to a corresponding gate line through a first via, and
the at least one of the plurality of touch electrode lead wires is connected to a corresponding touch electrode through a second via, and
the at least one of the plurality of gate lead wires, the at least one of the plurality of touch electrode lead wires, a source electrode, and a drain electrode are arranged in a same layer,
the at least one of the plurality of gate lead wires and the at least one of the plurality of touch electrode lead wires are aligned with one another, and the at least one of the plurality of touch electrode lead wires is arranged to be separated from a connection point between the at least one of the plurality of gate lead wires and the corresponding gate line by a distance, such that the at least one of the plurality of touch electrode lead wires and the at least one of the plurality of gate lead wires are insulated from each other,
wherein the gate IC is located at one side of the plurality of data lines and the touch IC is located at another side of the plurality of data lines, characterised in that
the at least one of the plurality of touch electrode lead wires is separated from the connection point between the at least one of the plurality of gate lead wires and the corresponding gate line along the direction that one of the plurality of data lines is aligned.

Optionally, the at least one of the plurality of gate lead wires, the at least one of the plurality of touch electrode lead wires, and the one of the plurality of data lines are made of a same material.

Optionally, the plurality of data lines is connected to a data IC and the touch IC is integrated in the data IC.

Optionally, one frame includes a display period and a touch-sensing period. In the display period, the plurality of gate lines receives gate signals from the gate IC through the plurality of gate lead wires connected to the gate lines, the plurality of data lines receives data signals from the data IC; and in the touch-sensing period, the touch electrode receives a touch signal from the touch IC through the at least one of the plurality of touch electrode lead wires.

Optionally, display substrate further includes a plurality of pixels arranged in an array, wherein two columns of pixels are arranged between two data lines, each one of two pixels in one row between the two data lines being connected to a different one of two adjacent gate lines.

Optionally, one of the plurality of gate lead wires and one of the plurality of touch lead wires are disposed between adjacent two columns of pixels between two data lines.

Another aspect of the present disclosure provides a display device, including one or more of the disclosed display substrates.

Another aspect of the present disclosure provides a fabrication method for forming the display substrate, including: forming a gate conductive layer on a substrate, the gate conductive layer including a plurality of gate lines; and forming a data conductive layer on the substrate, the data conductive layer including a plurality of data lines, a plurality of gate lead wires, and a plurality of touch electrode lead wires, the plurality of gate lead wires and the plurality of touch electrode lead wires form a one-to-one correspondence, the plurality of gate lead wires being connected to a gate integrated circuit (IC) and the plurality of touch electrode lead wires being connected to a touch IC, at least one of the plurality of gate lead wires and at least one of the plurality of touch electrode lead wires being along a same direction that one of the plurality of data lines is aligned, wherein the at least one of the plurality of gate lead wires is connected to a corresponding gate line through a first via, the at least one of the plurality of touch electrode lead wires is connected to a corresponding touch electrode through a second via, and the at least one of the plurality of gate lead wires, the at least one of the plurality of touch electrode lead wires, a source electrode, and a drain electrode are arranged in a same layer, the at least one of the plurality of gate lead wires and the at least one of the plurality of touch electrode lead wires are aligned with one another, wherein the end of the at least one of the plurality of touch electrode lead wires and the end of the at least one of the plurality of gate lead wires are facing each other, and the at least one of the plurality of touch electrode lead wires is arranged to be separated from a connection point between the at least one of the plurality of gate lead wires and the corresponding gate line by a distance, such that the at least one of the plurality of touch electrode lead wires and the at least one of the plurality of gate lead wires are insulated from each other, wherein the gate IC is located at one side of the plurality of data lines and the touchis located at another side of the plurality of data lines, characterised in that the at least one of the plurality of touch electrode lead wires is separated from the connection point between the at least one of the plurality of gate lead wires and the corresponding gate line along the direction that one of the plurality of data lines is aligned.

Optionally, the method further includes: forming a gate insulating layer between the gate conductive layer and the data conductive layer.

Optionally, the method further includes: forming a touch electrode layer, the touch electrode layer comprising a plurality of touch electrodes; and forming a planarization layer between the touch electrode layer and the data conductive layer.

In another aspect, the present invention provides a display apparatus comprising a touch control display panel described herein.

### BRIEF DESCRIPTION OF THE FIGURES

The following drawings are merely examples for illustrative purposes according to various disclosed embodiments and are not intended to limit the scope of the present invention.
FIG. 1 illustrates an exemplary display substrate according to various disclosed embodiments of the present disclosure;
FIG. 2 illustrates another exemplary display substrate according to various disclosed embodiments of the present disclosure;
FIG. 3 illustrates another exemplary display substrate according to various disclosed embodiments of the present disclosure;
FIG. 4 illustrates an exemplary process for fabricating a display substrate with a bottom-gated structure according to various disclosed embodiments of the present disclosure;
FIG. 5 illustrates a cross-sectional view of an exemplary display substrate according to various disclosed embodiments of the present disclosure;
FIG. 6 illustrates an exemplary process for fabricating a display substrate with a top-gated structure according to various disclosed embodiments of the present disclosure; and
FIG. 7 illustrates a cross-sectional view of another exemplary display substrate according to various disclosed embodiments of the present disclosure.

### DETAILED DESCRIPTION

The disclosure will now describe more specifically with reference to the following embodiments. It is to be noted that the following descriptions of some embodiments are presented herein for purpose of illustration and description only. It is not intended to be exhaustive or to be limited to the precise form disclosed.

For illustrative purposes, terms "intersect" and "intersection" are used to describe the positions of two or more lines not being parallel to each other, and do not infer any physical or electrical connection between any lines. One line being intersecting with another line refers to that the two lines are not disposed to be parallel to each other. The orthogonal projection of one line on the display substrate and the orthogonal projection of the other line on the display substrate may intersect.

In many instances, the display products with in-cell touch functions include two independent address scanning routes. One address scanning route often includes touch transmission lines and touch sensing lines to facilitate touch functions. The other address scanning route often includes gate lines and data lines to facilitate display functions. The two independent address scanning routes may result in relatively wide bezel in the in-cell touch products. In addition, when the gate lines and the data lines intersect with the touch transmission lines and touch sensing lines, display signals may interfere with touch signals. Touch functions and display functions of the display device may be impaired.

Embodiments consistent with the present disclosure provide a display substrate. Capacitive in-cell touch technology is applied in the pixels of the display substrate. Time-sharing driving methods may be applied to drive the display substrate. The display period and the touch-sensing period may be separated to prevent signal interference.

A display substrate, comprising: a plurality of gate lines, a plurality of data lines, a plurality of gate lead wires, and a plurality of touch electrode lead wires, each one of the plurality of gate lead wires configured for providing a gate signal to at least one of the plurality of gate lines, at least one of the plurality of touch electrode lead wires configured for transmitting a touch signal to a touch electrode, wherein at least one of the plurality of gate lead wires and at least one of the plurality of touch electrode lead wires are aligned along a direction that one of the plurality of data lines is aligned. The at least one of the plurality of gate lead wires and the at least one of the plurality of touch electrode lead wires are aligned with one another, wherein the end of the at least one of the plurality of touch electrode lead wires and the end of the at least one of the plurality of gate lead wires are facing each other.

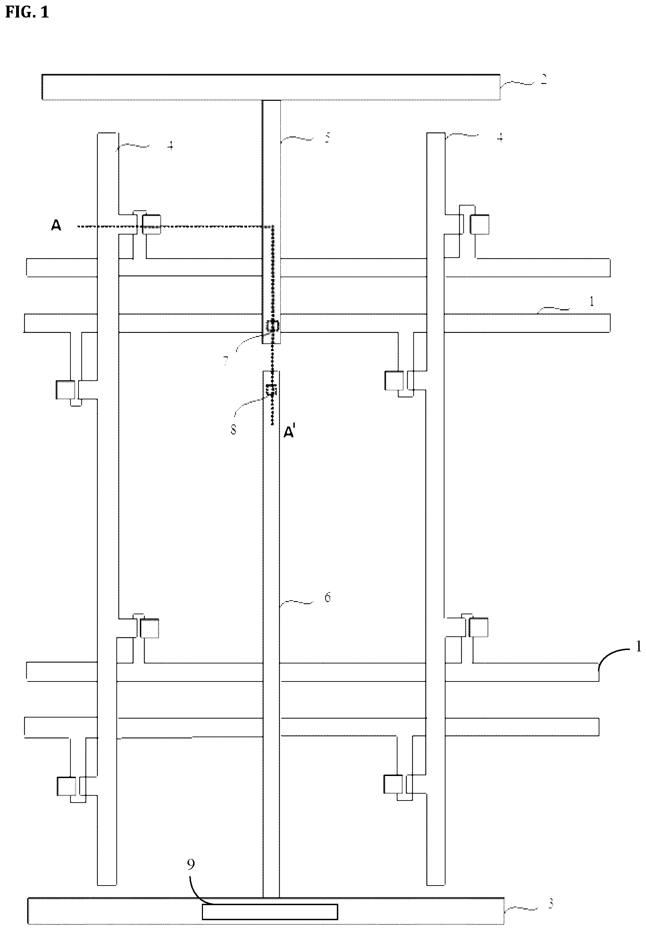

FIG. 1 illustrates a top view of an exemplary display substrate. As shown in FIG. 1, the display substrate includes a gate line 1, a gate integrated circuit (IC) 2, a data IC 3, a touch IC 9, and a data line 4. The gate line 1 and the data line 4 may be perpendicular to each other. One or more gate lines 1 are included in the display substrate, and one or more data lines 4 are included in the display substrate. In one embodiment, the touch IC 9 may be integrated in the data IC 3. In various other embodiments, the touch IC may not be integrated in the data IC. In some embodiments, two pixels in one row of pixels may be connected to and controlled by the two adjacent gate lines 1 disposed above and below the row of pixels (e.g., the two gate lines 1 labeled in FIG. 1). Two columns of pixels may be disposed between two adjacent data lines 4 (e.g., the two data lines 4 labeled in FIG. 1) on the left side and the on the right side of the two columns of pixels. Each one of the two pixels in one row, between the two data lines 4, may be connected to a different one of the adjacent gate lines 1, one gate line being above the two pixels and the other gate line being below the two pixels. The above arrangement of the gate lines may be referred to as a dual-gate design.

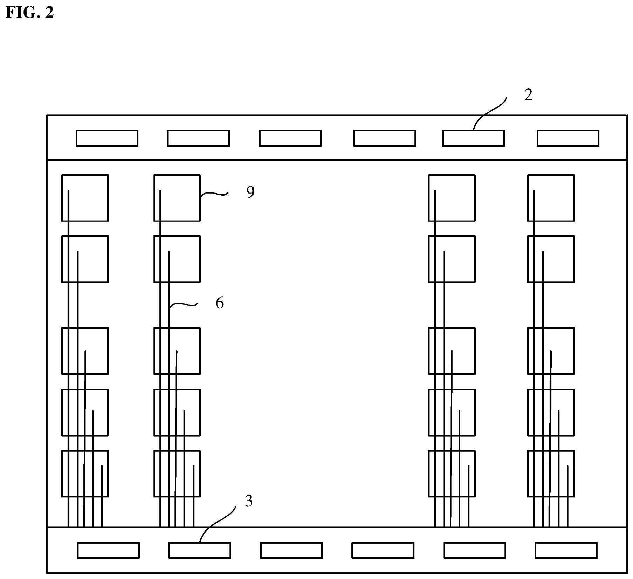

FIG. 2 illustrates a top view of another exemplary display substrate. As shown in FIG. 2, in the display substrate, the gate IC 2 and the data IC 3 are disposed to be opposing each other, where the touch IC may be integrated in the data IC 3. In FIGS. 1 and 2, the gate IC 2 and the data IC 3 may be disposed at two sides of a data line 4. The touch IC may be arranged at the same side with the data IC 3. The display substrate may include an array of M by N touch electrodes 9. The touch electrodes 9 may be configured to receive touch signals in a touch period in a frame, and may be used as common electrodes to receive driving signals in a display period in a frame. Each touch electrode 9 may be connected to the touch IC through a touch electrode lead wire 6.

The disclosed display substrate also includes a gate lead wire 5. The gate lead wire 5 transmits a gate signal to at least one gate lines 1.The gate lead wire 5 and the touch electrode lead wire 6 may be formed through a same fabrication step. As shown in FIG. 1, a touch electrode lead wire 6 corresponds to a gate lead wire 5. The gate lead wires 5 and the touch electrode lead wires 6 may be disposed between the gate IC 2 and the data IC 3. The gate lead wires 5 may be disposed to be on the side that is closer to the gate IC 2, and the touch electrode lead wires 6 may be disposed to be on the side that is closer to the data IC 3. A touch electrode lead wire 6 transmits a touch signal to a touch electrode. In some embodiments, at least one gate lead wire 5, at least one touch electrode lead wire 6, and the data lines 4 may be made of a same material through a same fabrication step.

In some embodiments, a gate lead wire 5 may be disposed on one side of the data lines 4. In some other embodiments, the gate lead wire 5 may be disposed between two adjacent data lines 4. In some embodiments, the touch electrode lead wire 6 may be disposed on one side of the data lines 4. In some other embodiments, the touch electrode lead wire 6 may be disposed between two adjacent data lines 4. In one embodiment, the gate lead wire 5 and the touch electrode lead wire 6 may be disposed between two adjacent data lines 4 for the dual gate design. By applying dual gate design, less data lines 4 may be used in the display substrate. Accordingly, the number of connection points between the data lines 4 and the data IC 3 may be reduced. The fabricated display substrate may be less costly.

**A** gate lead wire 5 is used to connect a corresponding gate line 1 with the gate IC 2. A gate lead wire 5 is configured to control the on (connected) and off (disconnected) states of the corresponding gate line 1. When the gate lines 1 are turned on, the display substrate may be turned on to perform display functions.

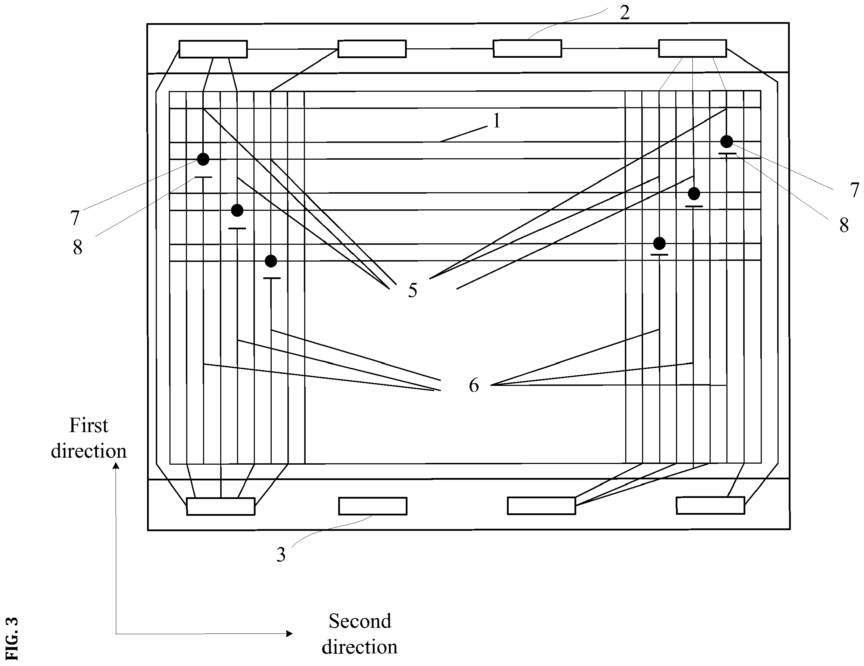

As shown in FIG. 3, the gate lead wires 5 connect the gate lines 1 with the gate IC 2. A black dot represents the connection point between a gate line 1 and a gate lead wire 5. At least one gate lead wires 5 is disposed from the gate IC 2 to the connection points with the gate lines 1, along the same direction the data lines 4 are aligned.

As shown in FIG. 3, touch electrode lead wires 6 are connected to the touch IC integrated in the data IC 3. At least one touch electrode lead wires 6 is disposed along the same direction the data lines 4 are aligned. A touch electrode lead wire 6 may be arranged to be separated from the connection point between a gate lead wire 5 and a gate line 1 by a certain distance, such that the touch electrode lead wires 6 and the gate lead wires 5 may be insulated from each other. The certain distance between a gate lead wire 5 and a touch electrode lead wire 6 may be any suitable value, e.g., about 1 cm and about 0.5 cm. By disposing the touch electrode lead wires 6 to be separated from the gate lead wires 5, narrow bezel of the display substrate may be easier to implement.

Referring to FIG. 1, the display substrate also includes a first via 7. A gate line 1 and a corresponding gate lead wire 5 may be connected through the first via 7. The gate line 1 is connected to the gate IC 2 through the gate lead wire 5. Thus, the gate line 1 may be turned on and off to implement switching functions, i.e., to turn on and off the display substrate. The display substrate may implement normal display functions.

As shown in FIGS. 1 and 2, the display substrate furthers include a second via 8. At least one touch electrode lead wire 6 is connected to a touch electrode 9 through the second via 8. The touch electrode 9 may be connected to the data IC 3 through the touch electrode lead wire 6 such that the touch electrode 9 may receive touch signals from the touch IC through the touch electrode lead wire 6 and proper touch functions may be implemented. One touch electrode 9 may be connected with or may correspond to one or more touch electrode lead wires 6. The touch electrode lead wires 6 corresponding to the same touch electrode 9 may transmit same touch signals. One touch electrode lead wire 6 may be connected with at least one touch electrode 9. In one embodiment, the touch electrodes 9 and the touch electrode lead wires 6 may form a one-to-one correspondence, as shown in FIG. 2. In this case, one gate lead wire 5 correspond to one touch electrode lead wire 6, and the gate lead wire 5 is aligned with the touch electrode lead wire 6 along the direction the data lines 4 are arranged. In one embodiment, the gate lead wires and the touch electrode lead wires may form a one-to-one correspondence.

For illustrative purposes, FIG. 1 only shows one structural unit of the display substrate. In practice, the display substrate may include a plurality of the structural units shown in FIG. 1. Details of other same structural units are not described herein.

Referring to FIGS. 1 and 3, the gate lines 1 may be arranged along a first direction between gate IC 2 and the data IC 3. The locations of the first vias 7, for connecting the gate lines 1 and the gate lead wires 5 and indicated as the black dots in FIG. 3, may have an ascending step-like shape along a second direction, or may have a descending step-like shape along the second direction. The locations of the second vias 8, for connecting the touch electrode lead wires 6 and the touch electrodes 9 and indicated as the short dashes in FIG. 3, may also have an ascending step-like shape along the second direction, or may have a descending step-like shape along the second direction. The arrangement of the second vias 8 may be designed according to the arrangement of the first vias 7. In some embodiments, the arrangement of the first vias 7 and the arrangement of the second via s 8 may be the same or similar. In some embodiments, the first direction may be parallel to the direction the data lines 4 are aligned, and the second direction may be parallel to the direction the gate lines 1 are aligned.

The present disclosure provides a display substrate. In the disclosed display substrate, a gate lead wire and the corresponding touch electrode lead wire are arranged to be separated from each other. Thus, interference between the signals transmitted by the gate lead wire and the corresponding touch electrode lead wire may be prevented. Display effect and touch effect of the display substrate may be improved. The gate lead wires and the touch electrode lead wires may not be arranged throughout the entire display substrate so that less space may be used for wiring. The display device containing the display substrate may have narrow bezel.

The display substrate may be operated under a time-sharing mode. In operation, each operating period, e.g., a frame, may include at least a display period and at least a touch-sensing period.

**As** shown in FIGS. 2 and 3, in a display period, the gate IC 2 may sequentially send a turn-on signal or a gate signal through each gate lead wire 5 to turn on or scan the gate line 1 connected to the gate lead wire 5. The gate lines 1 may be scanned according to a desired gate line scanning sequence such that pixels may be turned on sequentially. Meanwhile, the data IC 3 may sequentially send a data signal through each data line 4 according to the same gate line scanning sequence so that desired pixel data may be sent to the pixels. The touch electrodes 9 may be used as common electrodes in the display period. Thus, the disclosed display substrate may implement proper display functions.

In a touch-sensing period, as shown in FIG. 2, the touch IC may sequentially receive touch-sensing signals from the touch electrodes 9 through each touch electrode lead wire 6 for configuring touch motions. Columns of touch electrodes 9 may be scanned according to a desired touch scanning sequence. If a touch motion is performed on the display substrate, the touch IC may receive touch-sensing signals through the touch electrode lead wires 6 reflecting the capacitance change at the touch location. The touch IC may detect the touch motion and respond accordingly. Thus, the disclosed display substrate may implement proper touch functions.

The above-mentioned technical solutions may be combined in any suitable way to generate various embodiments of the present disclosure. Details of the combination are not repeated herein.

Another aspect of the present disclosure provides a display device. The display device may include one or more of the disclosed display substrates. The disclosed display substrate may be any one of the display substrate illustrated in FIGS. 1-3. In practice, the display device may be a smart phone, a tablet computer, a smart television, a laptop computer, a digital photo frame, a navigation device, or any other suitable products or parts with display functions.

In the disclosed display device, a gate lead wire and the corresponding touch electrode lead wire are arranged to be separated from each other. Thus, interference between the signals transmitted by the gate lead wire and the corresponding touch electrode lead wire may be prevented. Display effect and touch effect of the display substrate may be improved. The gate lead wires and the touch electrode lead wires are be arranged throughout the entire display substrate so that less space may be used for wiring. The display device containing the display substrate may have a narrow bezel.

The disclosed display substrate may have a bottom-gated structure or a top-gated structure. The fabrication processes of the display substrate with a bottom-gated structure and with a top-gate structure are now described in detail.

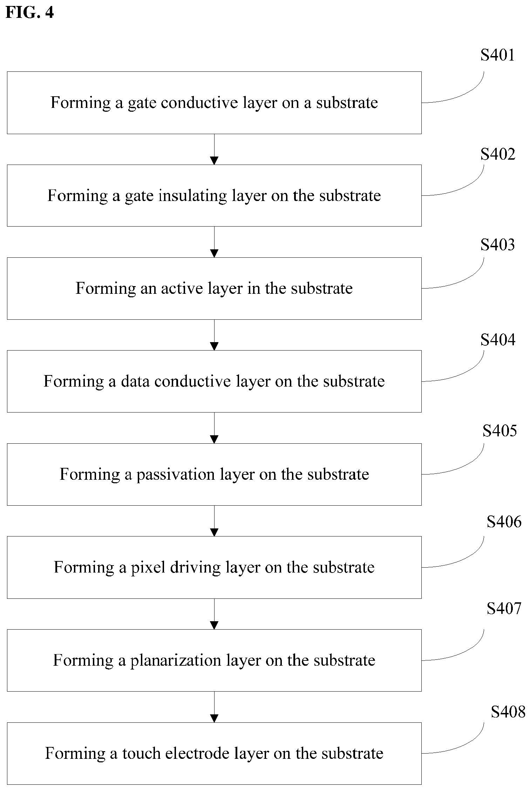

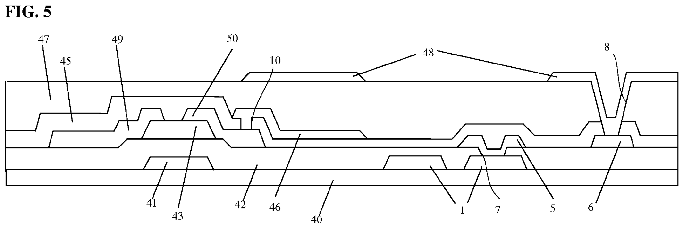

Another aspect of the present disclosure provides a fabrication method for forming a display substrate with a bottom-gated structure. An exemplary process flow of the fabrication method may be illustrated in FIG. 4. FIG. 5 illustrates a cross-sectional view of the display substrate along the AA' direction shown in FIG. 1. The film structure of the display substrate may be shown in FIG. 5. The fabrication method may include steps S401-S408.

In step S401, a gate conductive layer is formed on a substrate. Step S401 may further include steps S4011-S4013 (not shown).

In step S4011, the substrate 40 may be properly cleaned to prepare for the subsequent fabrication steps.

In step S4012, a deposition method may be used to form a gate conductive film on the substrate 40. In one embodiment, sputtering may be used to form the gate conductive film.

The gate conductive film may be a metal film made in one or more of Al, Cr, W, Ti, Ta, Mo, and Cu. The gate conductive film may also be a metal film made in at least two of Al, Cr, W, Ti, Ta, Mo, and Cu. The gate conductive film may also be a multiple-layered films, made of a plurality of different metals. The thickness of the gate conductive film may be between about 200 to about 1000 nm.

In step S4013, a patterning process may be used to form the gate conductive layer on the substrate 40. In some embodiments, the patterning process may include a photolithography process and a suitable etching process.

The photolithography process may be used to define the pattern of the gate conductive layer on the substrate 40. A wet etching process may be performed on the substrate 40. Further, the photoresist layer may be removed. The gate conductive layer may be formed on the substrate 40. The gate conductive layer may include a gate line 1 and a gate electrode 41.

In step S402, a gate insulating layer 42 may be formed on the substrate 40 to cover the gate conductive layer.

**A** deposition process may be used to form the gate insulating layer 42. In some embodiments, plasma enhanced chemical vapor deposition (PECVD) may be used to form a gate insulating film on the gate conductive layer. The gate insulating film may be a single-layered structure or a multiple-layered structure. The gate insulating film may be made of one or more of SiO₂, Si₃N₄, and SiOₓN_{y}. The thickness of the gate insulating film may be about 5 to about 300 nm. Further, a suitable patterning process may be used to form the first vias 7 in the gate insulating film. The gate insulating film with the first vias 7 may be referred as the gate insulating layer 42. In some embodiments, the patterning process may include a photolithography process and a suitable etching process.

In step S403, an active layer 43 may be formed on the substrate 40.

A deposition process, e.g., sputtering, may be used to form an active film on the gate insulating layer 42. In some embodiments, the active film may be made of one or more of IGZO, ZnO, ZnON, ITZO, and other suitable oxide materials. The active film may be a monobasic or multibasic oxide material. The thickness of the active film may be about 5 to about 250 nm. A patterning process may be used to define the pattern of the active layer from the active film. In some embodiments, the patterning process may include a photolithography process and a suitable etching process. For example, a wet etching process may be used to etch desired regions of the active film. Further, the photoresist may be removed. The active layer 43 may be formed on the gate insulating layer 42.

In step S404, a data conductive layer is formed on the substrate 40.

The data conductive layer includes a data line (not shown in FIG. 5), a gate lead wire 5, a touch electrode lead wire 6, a source electrode 49, and a drain electrode 50. The gate lead wire 5 and the touch electrode lead wire 6 are aligned along the direction the data line is arranged. Step S404 may include steps S4041-S4045 (not shown).

In step S4041, a source and drain metal film may be formed on the substrate 40 through a suitable deposition process.

In step S4042, a photoresist layer may be coated on the source and drain metal film.

In step S4043, a mask may be used for exposing the photoresist layer.

In step S4044, the exposed photoresist layer may be developed.

In step S4045, an etching process may be performed on the developed photoresist layer to form the data conductive layer. The gate lead wire 5 may be connected to a gate line 1 through a first via 7.

In step S405, a passivation layer 45 may be formed on the substrate 40.

**A** suitable deposition process may be used to form the passivation material film. In some embodiments, PECVD may be used to form the passivation material film. A patterning process may be used to define the pattern of a third via 10. The patterning process may include a photolithography process and an etching process. In some embodiments, a dry etching process may be performed on the passivation material film to form the third via 10, and the passivation layer 45 may be formed.

In step S406, a pixel driving layer 46 may be formed on the substrate 40.

**An** indium tin oxide (ITO) film may be deposited on the substrate 40. A patterning process may be performed to form the pixel driving layer 46. The pixel driving layer 46 may be connected to the drain electrode 50 through the third via 10.

In step S407, a planarization layer 47 may be formed on the substrate 40.

**A** suitable deposition process may be performed to deposit a planarization material film on the substrate 40. In some embodiments, PECVD may be used to form the planarization material film. The planarization film may be made of an inorganic material. A patterning process may be used to define the pattern of the second via 8. The patterning process may include a photolithography process and an etching process. In some embodiments, a dry etching process may be used to etch the planarization material film. Further, the photoresist layer may be removed to form the planarization layer 47. The second via 8 may sequentially pass through the planarization layer 47 and the passivation layer 45 to contact the touch electrode lead wire 6.

In step S408, a touch electrode layer 48 may be formed on the substrate 40.

**An** ITO film may be formed on the substrate 40. A suitable patterning process may be used to form the touch electrode layer 48. The touch electrode layer 48 may include a plurality of touch electrodes 9. A touch electrode 9 may be connected to a touch electrode lead wire 6 through a second via 8.

In the display substrate formed through the described process, the gate conductive layer includes the gate line, the data conductive layer includes the data line, the gate lead wire, and the touch electrode lead wire. Further, the touch electrode layer includes a plurality of touch electrodes. The gate insulating layer includes the first via. The gate lead wire and the gate line are connected through the first via. The second via is formed on the touch electrode lead wire such that the touch electrode and the touch electrode lead wire may form a one-to-one correspondence through the second via.

In the disclosed fabrication method, a gate lead wire and the touch electrode lead wire under the gate lead are arranged to be separated from each other. Thus, interference between the signals transmitted by the gate lead wire and the corresponding touch electrode lead wire may be prevented. Display effect and touch effect of the display substrate may be improved. The gate lead wires and the touch electrode lead wires are not arranged throughout the entire display substrate so that less space may be used for wiring. The display device containing the display substrate may have narrow bezel.

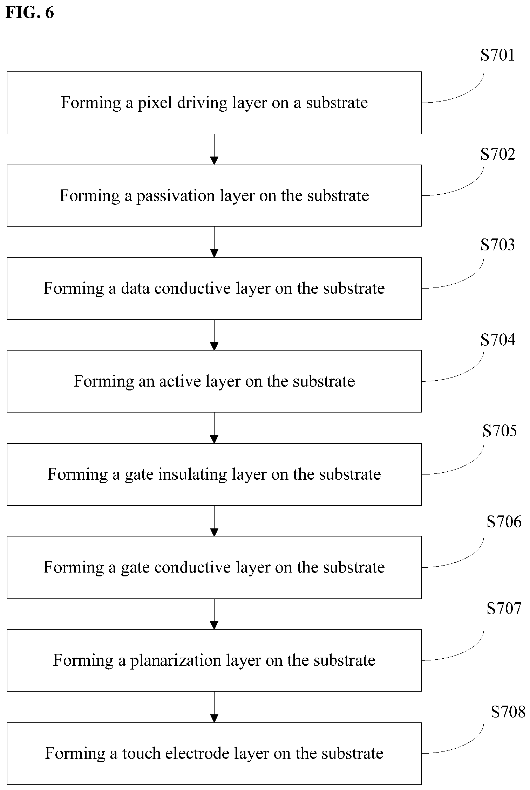

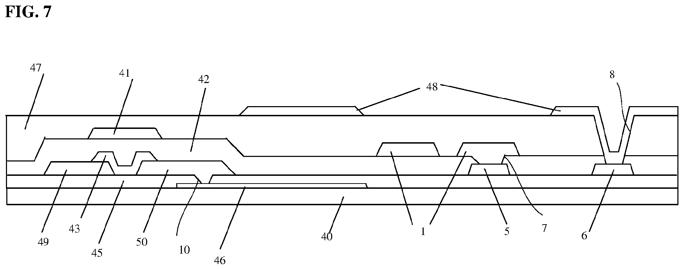

The present disclosure also provides a display substrate with a top-gated structure. FIG. 6 illustrates an exemplary process flow to fabricate the display substrate with a top-gated structure. FIG. 7 illustrates a cross-sectional view of the display substrate fabricated through the disclosed fabrication method. The cross-sectional view of the display substrate shown in FIG. 7 may be substantially along the same direction as in FIG. 5.

In step S701, a pixel driving layer 46 may be formed on a substrate 40.

In some embodiments, an ITO film may be formed on the substrate 40. A patterning process may be performed to form the pixel driving layer 46.

In step S702, a passivation layer 45 may be formed on the substrate 40.

In some embodiments, a suitable deposition process may be used to form a passivation material film. In some embodiments, PECVD may be used to form the passivation material film. A patterning process, e.g., including a photolithography process and an etching process, may be used to form the passivation layer 45. In some embodiments, a photolithography process may be used to define a third via 10. A dry etching process may be performed to form the third via 10 and the photoresist may be removed. The passivation layer 45 may be formed.

In step S703, a data conductive layer is formed on the substrate 40.

The data conductive layer includes a source electrode 49, a drain electrode, a gate lead wire 5, and a touch electrode lead wire 6. The process to form the data conductive layer may include steps S7031-S7035 (not shown).

In step S7031, a source and drain metal film may be formed on the substrate 40, through a suitable deposition method.

In step S7032, a photoresist layer may be coated on the source and drain metal film.

In step S7033, a mask may be used to expose the photoresist layer on the substrate 40.

In step S7034, the exposed photoresist layer may be developed.

In step S7035, an etching process may be performed on the substrate 40 after the development to form the data conductive layer. The drain electrode 50 may be connected to the pixel driving layer 46 through the third via 10.

In step S704, an active layer 43 may be formed on the substrate 40.

A deposition process, e.g., sputtering, may be used to form an active film on substrate 40. In some embodiments, the active film may be made of one or more of IGZO, ZnO, ZnON, ITZO, and other suitable oxide materials. The active film may be a monobasic or multibasic oxide material. The thickness of the active film may be about 5 to about 250 nm. A patterning process may be used to define the pattern of the active layer from the active film. In some embodiments, the patterning process may include a photolithography process and a suitable etching process. For example, a wet etching process may be used to etch desired regions of the active film. Further, the photoresist may be removed. The active layer 43 may be formed on the substrate 40.

In step S705, a gate insulating layer 42 may be formed on the substrate 40.

**A** suitable deposition process may be used to form the gate insulating layer 42. In some embodiments, plasma enhanced chemical vapor deposition (PECVD) may be used to form a gate insulating film on the gate conductive layer on the active layer 43. The gate insulating film may be a single-layered structure or a multiple-layered structure. The gate insulating film may be made of one or more of SiO₂, Si₃N₄, and SiOₓN_{y}. The thickness of the gate insulating film may be about 5 to about 300 nm. Further, a suitable patterning process may be used to form the first vias 7 in the gate insulating film. The gate insulating film with the first vias 7 may be referred as the gate insulating layer 42. In some embodiments, the patterning process may include a photolithography process and a suitable etching process.

In step S706, a gate conductive layer is formed on the substrate 40.

A photolithography process may be used to define the pattern of the gate conductive layer on the substrate 40. A wet etching process may be performed on the substrate 40. Further, the photoresist layer may be removed. The gate conductive layer may be formed on the substrate 40. The gate conductive layer includes a gate line 1 and a gate electrode 41.

In step S707, a planarization layer 47 may be formed on the substrate 40.

**A** deposition process may be performed to deposit a planarization material film on the substrate 40. In some embodiments, PECVD may be used to form the planarization material film. The planarization film may be made of an inorganic material. A patterning process may be used to define the pattern of the second via 8. The patterning process may include a photolithography process and an etching process. In some embodiments, a dry etching process may be used to etch the planarization material film. Further, the photoresist layer may be removed to form the planarization layer 47. The second via 8 may sequentially pass through the planarization layer 47 and the gate insulating layer 42 to contact the touch electrode lead wire 6.

In step S708, a touch electrode layer 48 may be formed in the substrate 40.

**An** ITO film may be formed on the substrate 40. A suitable patterning process may be used to form the touch electrode layer 48. The touch electrode layer 48 may include a plurality of touch electrodes 9. A touch electrode 9 may be connected to a touch electrode lead wire 6 through a second via 8.

In the display substrate formed through the described process, the gate conductive layer includes the gate line, the data conductive layer may include the data line, the gate lead wire, and the touch electrode lead wire. Further, the touch electrode layer includes a plurality of touch electrodes. The gate insulating layer includes the first via. The gate lead wire and the gate line are connected through the first via. The second via is formed on the touch electrode lead wire such that the touch electrode and the touch electrode lead wire may form a one-to-one correspondence through the second via.

In the disclosed fabrication method, a gate lead wire and the touch electrode lead wire under the gate lead wire are arranged to be separated from each other. Thus, interference between the signals transmitted by the gate lead wire and the corresponding touch electrode lead wire may be prevented. Display effect and touch effect of the display substrate may be improved. The gate lead wires and the touch electrode lead wires are not be arranged throughout the entire display substrate so that less space may be used for wiring. The display device containing the display substrate may have a narrow bezel.

Those skilled in the art should understand that, at least part of the processes described in the embodiments may be implemented through hardware and/or related software. The computer programs to execute commands may be stored in a readable computer medium. The readable computer medium may be a read-only storage device, a hard disc, and/or an optical disc. The foregoing description of the embodiments of the invention has been presented for purposes of illustration and description. Obviously, many modifications and variations will be apparent to practitioners skilled in this art. The embodiments are chosen and described in order to best explain the principles of the invention and its best mode practical application, thereby to enable persons skilled in the art to understand the invention for various embodiments and with various modifications as are suited to the particular use or implementation contemplated. It is intended that the scope of the invention be defined by the claims appended hereto in which all terms are meant in their broadest reasonable sense unless otherwise indicated. Therefore, the term "the invention", "the present invention" or the like does not necessarily limit the claim scope to a specific embodiment, and the reference to exemplary embodiments of the invention does not imply a limitation on the invention, and no such limitation is to be inferred. The invention is limited only by the scope of the appended claims. Moreover, these claims may refer to use "first", "second", etc. following with noun or element. Such terms should be understood as a nomenclature and should not be construed as giving the limitation on the number of the elements modified by such nomenclature unless specific number has been given. Any advantages and benefits described may not apply to all embodiments of the invention. It should be appreciated that variations may be made in the embodiments described by persons skilled in the art without departing from the scope of the present invention as defined by the following claims.

## Claims

1. A display substrate, comprising: a plurality of gate lines (1), a plurality of data lines (4), a plurality of gate lead wires (5), and a plurality of touch electrode lead wires (6), the plurality of gate lead wires (5) and the plurality of touch electrode lead wires (6) form a one-to-one correspondence, the plurality of gate lead wires (5) being connected to a gate integrated circuit (IC) (2) and the plurality of touch electrode lead wires (6) being connected to a touch IC, each one of the plurality of gate lead wires (5) configured for providing a gate signal to at least one of the plurality of gate lines (1), at least one of the plurality of touch electrode lead wires (6) configured for transmitting a touch signal to a touch electrode (9), wherein:
at least one of the plurality of gate lead wires (5) and at least one of the plurality of touch electrode lead wires (6) are aligned along a direction that one of the plurality of data lines (4) is aligned, wherein the end of the at least one of the plurality of touch electrode lead wires (6) and the end of the at least one of the plurality of gate lead wires (5) are facing each other,
the at least one of the plurality of gate lead wires (5) is connected to a corresponding gate line (1) through a first via (7), and
the at least one of the plurality of touch electrode lead wires (6) is connected to a corresponding touch electrode through a second via (8), and
the at least one of the plurality of gate lead wires (5), the at least one of the plurality of touch electrode lead wires (6), a source electrode (49), and a drain electrode (50) are arranged in a same layer,
the at least one of the plurality of gate lead wires (5) and the at least one of the plurality of touch electrode lead wires (6) are aligned with one another, and the at least one of the plurality of touch electrode lead wires (6) is arranged to be separated from a connection point between the at least one of the plurality of gate lead wires (5) and the corresponding gate line (1) by a distance, such that the at least one of the plurality of touch electrode lead wires (6) and the at least one of the plurality of gate lead wires (5) are insulated from each other,
wherein the gate IC (2) is located at one side of the plurality of data lines (4) and the touch IC is located at another side of the plurality of data lines (4),
the at least one of the plurality of touch electrode lead wires (6) is separated from the connection point between the at least one of the plurality of gate lead wires (5) and the corresponding gate line (1) along the direction that one of the plurality of data lines (4) is aligned.

2. The display substrate according to claim 1, wherein the at least one of the plurality of gate lead wires (5), the at least one of the plurality of touch electrode lead wires (6), and the one of the plurality of data lines (4) are made of a same material.

3. The display substrate according to claim 1, wherein the plurality of data lines (4) is connected to a data IC (3) and the touch IC is integrated in the data IC (3).

4. The display substrate according to claim 3, one frame comprising a display period and a touch-sensing period, wherein in the display period, the plurality of gate lines (1) receives gate signals from the gate IC (2) through the plurality of gate lead wires (5) connected to the gate lines (1), the plurality of data lines (4) receives data signals from the data IC (3); and in the touch-sensing period, the touch electrode (9) receives a touch signal from the touch IC through the at least one of the plurality of touch electrode lead wires (6).

5. The display substrate according to claim 1, further comprising a plurality of pixels arranged in an array, wherein two columns of pixels are arranged between two data lines (4), each one of two pixels in one row between the two data lines (4) being connected to a different one of two adjacent gate lines (1).

6. The display substrate according to claim 5, wherein one of the plurality of gate lead wires (5) and one of the plurality of touch electrode lead wires (6) are disposed between adjacent two columns of pixels between two data lines (4).

7. A display device, comprising one or more of the display substrates according to any one of claims 1-6.

8. A fabrication method for forming the display substrate, comprising:
forming a gate conductive layer on a substrate (40), the gate conductive layer including a plurality of gate lines (1); and
forming a data conductive layer on the substrate (40), the data conductive layer including a plurality of data lines (4), a plurality of gate lead wires (5), and a plurality of touch electrode lead wires (6), the plurality of gate lead wires (5) and the plurality of touch electrode lead wires (6) form a one-to-one correspondence, the plurality of gate lead wires (5) being connected to a gate integrated circuit (IC) (2) and the plurality of touch electrode lead wires (6) being connected to a touch IC, at least one of the plurality of gate lead wires (5) and at least one of the plurality of touch electrode lead wires (6) being along a same direction that one of the plurality of data lines (4) is aligned, wherein
the at least one of the plurality of gate lead wires (5) is connected to a corresponding gate line (1) through a first via (7), the at least one of the plurality of touch electrode lead wires (5) is connected to a corresponding touch electrode through a second via (8), and
the at least one of the plurality of gate lead wires (5), the at least one of the plurality of touch electrode lead wires (6), a source electrode (49), and a drain electrode (50) are arranged in a same layer,
the at least one of the plurality of gate lead wires (5) and the at least one of the plurality of touch electrode lead wires (6) are aligned with one another, wherein the end of the at least one of the plurality of touch electrode lead wires (6) and the end of the at least one of the plurality of gate lead wires (5) are facing each other,
and the at least one of the plurality of touch electrode lead wires (6) is arranged to be separated from a connection point between the at least one of the plurality of gate lead wires (5) and the corresponding gate line (1) by a distance, such that the at least one of the plurality of touch electrode lead wires (6) and the at least one of the plurality of gate lead wires (5) are insulated from each other,
wherein the gate IC (2) is located at one side of the plurality of data lines (4) and the touch IC is located at another side of the plurality of data lines (4),
the at least one of the plurality of touch electrode lead wires (6) is separated from the connection point between the at least one of the plurality of gate lead wires (5) and the corresponding gate line (1) along the direction that one of the plurality of data lines (4) is aligned.

9. The method according to claim 8, further comprising:
forming a gate insulating layer (42) between the gate conductive layer and the data conductive layer.

10. The method according to claim 9, further comprising:
forming a touch electrode layer (48), the touch electrode layer (48) comprising a plurality of touch electrodes (9); and
forming a planarization layer (47) between the touch electrode layer (48) and the data conductive layer.

## Patentansprüche

1. Anzeigesubstrat, aufweisend: mehrere Gate-Leitungen (1), mehrere Datenleitungen (4), mehrere Gate-Zuleitungsdrähte (5) und mehrere Berührungselektroden-Zuleitungsdrähte (6), wobei die mehreren Gate-Zuleitungsdrähte (5) und die mehreren Berührungselektroden-Zuleitungsdrähte (6) eine Einszu-Eins-Entsprechung bilden, wobei die mehreren Gate-Zuleitungsdrähte (5) mit einem integrierten Gate-Schaltkreis (IC) (2) verbunden sind und die mehreren Berührungselektroden-Zuleitungsdrähte (6) mit einem Berührungs-IC verbunden sind, wobei jeder der mehreren Gate-Zuleitungsdrähte (5) konfiguriert ist, um an mindestens eine der mehreren Gate-Leitungen (1) ein Gate-Signal zu liefern, wobei mindestens einer der mehreren Berührungselektroden-Zuleitungsdrähte (6) konfiguriert ist, um ein Berührungssignal an eine Berührungselektrode (9) zu übertragen, wobei
mindestens einer der mehreren Gate-Zuleitungsdrähte (5) und mindestens einer der mehreren Berührungselektroden-Zuleitungsdrähte (6) entlang einer Richtung ausgerichtet sind, in der eine der mehreren Datenleitungen (4) ausgerichtet ist, wobei das Ende des mindestens einen der mehreren Berührungselektroden-Zuleitungsdrähte (6) und das Ende des mindestens einen der mehreren Gate-Zuleitungsdrähte (5) einander zugewandt sind,
der mindestens eine der mehreren Gate-Zuleitungsdrähte (5) über eine erste Durchkontaktierung (7) mit einer entsprechenden Gate-Leitung (1) verbunden ist, und
der mindestens eine der mehreren Berührungselektroden-Zuleitungsdrähte (6) über eine zweite Durchkontaktierung (8) mit einer entsprechenden Berührungselektrode verbunden ist, und
der mindestens eine der mehreren Gate-Zuleitungsdrähte (5), der mindestens eine der mehreren Berührungselektroden-Zuleitungsdrähte (6), eine Source-Elektrode (49) und eine Drain-Elektrode (50) in derselben Schicht angeordnet sind,
der mindestens eine der mehreren Gate-Zuleitungsdrähte (5) und der mindestens eine der mehreren Berührungselektroden-Zuleitungsdrähte (6) miteinander ausgerichtet sind und der mindestens eine der mehreren Berührungselektroden-Zuleitungsdrähte (6) angeordnet ist, um von einem Verbindungspunkt zwischen dem mindestens einen der mehreren Gate-Zuleitungsdrähte (5) und der entsprechenden Gate-Leitung (1) durch einen Abstand getrennt zu sein, so dass der mindestens eine der mehreren Berührungselektroden-Zuleitungsdrähte (6) und der mindestens eine der mehreren Gate-Zuleitungsdrähte (5) voneinander isoliert sind,
wobei der Gate-IC (2) auf einer Seite der mehreren Datenleitungen (4) und der Berührungs-IC auf einer anderen Seite der mehreren Datenleitungen (4) angeordnet ist,
der mindestens eine der mehreren Berührungselektroden-Zuleitungsdrähte (6) von dem Verbindungspunkt zwischen dem mindestens einen der mehreren Gate-Zuleitungsdrähte (5) und der entsprechenden Gate-Leitung (1) entlang der Richtung, in der eine der mehreren Datenleitungen (4) ausgerichtet ist, getrennt ist.

2. Anzeigesubstrat nach Anspruch 1, wobei der mindestens eine der mehreren Gate-Zuleitungsdrähte (5), der mindestens eine der mehreren Berührungselektroden-Zuleitungsdrähte (6) und die eine der mehreren Datenleitungen (4) aus demselben Material hergestellt sind.

3. Anzeigesubstrat nach Anspruch 1, wobei die mehreren Datenleitungen (4) mit einem Daten-IC (3) verbunden sind und der Berührungs-IC in den Daten-IC (3) integriert ist.

4. Anzeigesubstrat nach Anspruch 3, wobei ein Einzelbild eine Anzeigeperiode und eine Berührungserfassungsperiode umfasst, wobei in der Anzeigeperiode die mehreren Gate-Leitungen (1) über die mehreren Gate-Zuleitungsdrähte (5), die mit den Gate-Leitungen (1) verbunden sind, Gate-Signale von dem Gate-IC (2) empfangen, die mehreren Datenleitungen (4) Datensignale von dem Daten-IC (3) empfangen; und in der Berührungserfassungsperiode die Berührungselektrode (9) über mindestens einen der mehreren Berührungselektroden-Zuleitungsdrähte (6) ein Berührungssignal von dem Berührungs-IC empfängt.

5. Anzeigesubstrat nach Anspruch 1, ferner mehrere Pixel aufweisend, die in einem Array angeordnet sind, wobei zwei Spalten von Pixeln zwischen zwei Datenleitungen (4) angeordnet sind, wobei jedes von zwei Pixeln in einer Reihe zwischen den zwei Datenleitungen (4) mit einer anderen von zwei benachbarten Gate-Leitungen (1) verbunden ist.

6. Anzeigesubstrat nach Anspruch 5, wobei einer der mehreren Gate-Zuleitungsdrähte (5) und einer der mehreren Berührungselektroden-Zuleitungsdrähte (6) zwischen zwei benachbarten Spalten von Pixeln zwischen zwei Datenleitungen (4) angeordnet sind.

7. Anzeigevorrichtung, ein oder mehrere der Anzeigesubstrate nach einem der Ansprüche 1 bis 6 aufweisend.

8. Herstellungsverfahren zum Bilden des Anzeigesubstrats, umfassend:
Bilden einer Gate-Leiterschicht auf einem Substrat (40), wobei die Gate-Leiterschicht mehrere Gate-Leitungen (1) aufweist; und
Bilden einer Daten-Leiterschicht auf dem Substrat (40), wobei die Daten-Leiterschicht mehrere Datenleitungen (4), mehrere Gate-Zuleitungsdrähte (5) und mehrere Berührungselektroden-Zuleitungsdrähte (6) aufweist, wobei die mehreren Gate-Zuleitungsdrähte (5) und die mehreren Berührungselektroden-Zuleitungsdrähte (6) eine Einszu-Eins-Entsprechung bilden, die mehreren Gate-Zuleitungsdrähte (5) mit einem integrierten Gate-Schaltkreis (IC) (2) verbunden werden und die mehreren Berührungselektroden-Zuleitungsdrähte (6) mit einem Berührungs-IC verbunden werden, wobei mindestens einer der mehreren Gate-Zuleitungsdrähte (5) und mindestens einer der mehreren Berührungselektroden-Zuleitungsdrähte (6) entlang derselben Richtung verläuft, in der eine der mehreren Datenleitungen (4) ausgerichtet ist, wobei
der mindestens eine der mehreren Gate-Zuleitungsdrähte (5) über eine erste Durchkontaktierung (7) mit einer entsprechenden Gate-Leitung (1) verbunden wird, der mindestens eine der mehreren Berührungselektroden-Zuleitungsdrähte (5) über eine zweite Durchkontaktierung (8) mit einer entsprechenden Berührungselektrode verbunden wird, und
der mindestens eine der mehreren Gate-Zuleitungsdrähte (5), der mindestens eine der mehreren Berührungselektroden-Zuleitungsdrähte (6),
eine Source-Elektrode (49) und eine Drain-Elektrode (50) in derselben Schicht angeordnet werden,
der mindestens eine der mehreren Gate-Zuleitungsdrähte (5) und der mindestens eine der mehreren Berührungselektroden-Zuleitungsdrähte (6) miteinander ausgerichtet werden, wobei das Ende des mindestens einen der mehreren Berührungselektroden-Zuleitungsdrähte (6) und das Ende des mindestens einen der mehreren Gate-Zuleitungsdrähte (5) einander zugewandt sind,
und der mindestens eine der mehreren Berührungselektroden-Zuleitungsdrähte (6) angeordnet wird, um von einem Verbindungspunkt zwischen dem mindestens einen der mehreren Gate-Zuleitungsdrähte (5) und der entsprechenden Gate-Leitung (1) durch einen Abstand getrennt zu werden, so dass der mindestens eine der mehreren Berührungselektroden-Zuleitungsdrähte (6) und der mindestens eine der mehreren Gate-Zuleitungsdrähte (5) voneinander isoliert werden,
wobei der Gate-IC (2) auf einer Seite der mehreren Datenleitungen (4) und der Berührungs-IC auf einer anderen Seite der mehreren Datenleitungen (4) angeordnet wird,
der mindestens eine der mehreren Berührungselektroden-Zuleitungsdrähte (6) von dem Verbindungspunkt zwischen dem mindestens einen der mehreren Gate-Zuleitungsdrähte (5) und der entsprechenden Gate-Leitung (1) entlang der Richtung getrennt wird, in der eine der mehreren Datenleitungen (4) ausgerichtet ist.

9. Verfahren nach Anspruch 8, ferner umfassend:
Bilden einer Gate-Isolierschicht (42) zwischen der Gate-Leiterschicht und der Daten-Leiterschicht.

10. Verfahren nach Anspruch 9, ferner umfassend:
Bilden einer Berührungselektrodenschicht (48), wobei die Berührungselektrodenschicht (48) mehrere Berührungselektroden (9) aufweist; und
Bilden einer Planarisierungsschicht (47) zwischen der Berührungselektrodenschicht (48) und der Daten-Leiterschicht.

## Revendications

1. Substrat d'affichage, comprenant : une pluralité de lignes de grille (1), une pluralité de lignes de données (4), une pluralité de fils conducteurs de grille (5), et une pluralité de fils conducteurs d'électrode tactile (6), la pluralité de fils conducteurs de grille (5) et la pluralité de fils conducteurs d'électrode tactile (6) forment une correspondance de un à un, la pluralité de fils conducteurs de grille (5) étant connectés à un circuit intégré (IC) de grille (2) et la pluralité de fils conducteurs d'électrode tactile (6) étant connectés à un IC tactile, chaque fil de la pluralité de fils conducteurs de grille (5) étant configuré pour fournir un signal de grille à au moins une ligne parmi la pluralité de lignes de grille (1), au moins un fil parmi la pluralité de fils conducteurs d'électrode tactile (6) étant configuré pour transmettre un signal tactile à une électrode tactile (9), dans lequel :
au moins un fil parmi la pluralité de fils conducteurs de grille (5) et au moins un fil parmi la pluralité de fils conducteurs d'électrode tactile (6) sont alignés le long d'une direction dans laquelle une ligne parmi la pluralité de lignes de données (4) est alignée, dans lequel l'extrémité dudit au moins un fil parmi la pluralité de fils conducteurs d'électrode tactile (6) et l'extrémité dudit au moins un fil parmi la pluralité de fils conducteurs de grille (5) se font face,
ledit au moins un fil parmi la pluralité de fils conducteurs de grille (5) est connecté à une ligne de grille correspondante (1) par un premier via (7), et ledit au moins un fil parmi la pluralité de fils conducteurs d'électrode tactile (6) est connecté à une électrode tactile correspondante par un deuxième via (8), et ledit au moins un fil parmi la pluralité de fils conducteurs de grille (5), ledit au moins un fil parmi la pluralité de fils conducteurs d'électrode tactile (6), une électrode de source (49) et une électrode de drain (50) sont agencés dans une même couche,
ledit au moins un fil parmi la pluralité de fils conducteurs de grille (5) et ledit au moins un fil parmi la pluralité de fils conducteurs d'électrode tactile (6) sont alignés l'un avec l'autre, et ledit au moins un fil parmi la pluralité de fils conducteurs d'électrode tactile (6) est agencé pour être séparé d'un point de connexion entre au moins un fil parmi la pluralité de fils conducteurs de grille (5) et la ligne de grille correspondante (1) d'une distance, de sorte que ledit au moins un fil parmi la pluralité de fils conducteurs d'électrodes tactiles (6) et ledit au moins un fil parmi la pluralité de fils conducteurs de grille (5) sont isolés les uns des autres,
dans lequel le IC de grille (2) est situé d'un côté de la pluralité de lignes de données (4) et le IC tactile est situé d'un autre côté de la pluralité de lignes de données (4),
ledit au moins un fil parmi la pluralité de fils conducteurs d'électrode tactile (6) est séparé du point de connexion entre ledit au moins un fil parmi la pluralité de fils conducteurs de grille (5) et la ligne de grille correspondante (1) le long de la direction dans laquelle une ligne parmi la pluralité de lignes de données (4) est alignée.

2. Substrat d'affichage selon la revendication 1, dans lequel au moins un fil parmi la pluralité de fils conducteurs de grille (5), ledit au moins un fil parmi la pluralité de fils conducteurs d'électrode tactile (6) et un fil parmi la pluralité de fils conducteurs de lignes de données (4) sont réalisées dans un même matériau.

3. Substrat d'affichage selon la revendication 1, dans lequel la pluralité de lignes de données (4) est connectée à un IC de données (3) et le IC tactile est intégré dans le IC de données (3).

4. Substrat d'affichage selon la revendication 3, une trame comprenant une période d'affichage et une période de détection de toucher, dans lequel, dans la période d'affichage, la pluralité de lignes de grille (1) reçoit des signaux de grille du IC de grille (2) à travers la pluralité de fils conducteurs de grille (5) connectés aux lignes de grille (1), la pluralité de lignes de données (4) reçoit des signaux de données du IC de données (3) ; et dans la période de détection tactile, l'électrode tactile (9) reçoit un signal tactile du IC tactile à travers au moins un fil parmi la pluralité de fils conducteurs d'électrode tactile (6).

5. Substrat d'affichage selon la revendication 1, comprenant en outre une pluralité de pixels agencés en un réseau, dans lequel deux colonnes de pixels sont agencées entre deux lignes de données (4), chacun de deux pixels dans une rangée entre les deux lignes de données (4) étant connecté à une ligne différente parmi deux lignes de grille adjacentes (1).

6. Substrat d'affichage selon la revendication 5,
dans lequel un fil parmi la pluralité de fils conducteurs de grille (5) et un fil parmi la pluralité de fils conducteurs d'électrode tactile (6) sont disposés entre deux colonnes adjacentes de pixels entre deux lignes de données (4).

7. Dispositif d'affichage, comprenant un ou plusieurs des substrats d'affichage selon l'une quelconque des revendications 12.

8. Procédé de fabrication pour former le substrat d'affichage, comprenant les étapes consistant à :
former une couche conductrice de grille sur un substrat (40), la couche conductrice de grille comprenant une pluralité de lignes de grille (1) ; et
former une couche conductrice de données sur le substrat (40), la couche conductrice de données comprenant une pluralité de lignes de données (4), une pluralité de fils conducteurs de grille (5), et une pluralité de fils conducteurs d'électrode tactile (6), la pluralité de fils conducteurs de grille (5) et la pluralité de fils conducteurs d'électrode tactile (6) forment une correspondance de un à un, la pluralité de fils conducteurs de grille (5) étant connectée à un circuit intégré (IC) de grille (2) et la pluralité de fils conducteurs d'électrode tactile (6) étant connectée à un IC tactile, au moins un fil parmi la pluralité de fils conducteurs de grille (5) et
au moins un fil parmi la pluralité de fils conducteurs d'électrode tactile (6) étant le long d'une même direction dans laquelle une ligne parmi la pluralité de lignes de données (4) est alignée, dans lequel ledit au moins un fil parmi la pluralité de fils conducteurs de grille (5) est connecté à une ligne de grille correspondante (1) par un premier via (7), ledit au moins un fil parmi la pluralité de fils conducteurs d'électrode tactile (5) est connecté à une électrode tactile correspondante à travers un second via (8), et
ledit au moins un fil parmi la pluralité de fils conducteurs de grille (5), ledit au moins un fil parmi la pluralité de fils conducteurs d'électrode tactile (6), une électrode de source (49) et une électrode de drain (50) sont agencés dans une même couche,
ledit au moins un fil parmi la pluralité de fils conducteurs de grille (5) et ledit au moins un fil parmi la pluralité de fils conducteurs d'électrode tactile (6) sont alignés l'un avec l'autre, dans lequel l'extrémité dudit au moins un fil parmi la pluralité de fils conducteurs d'électrode tactile (6) et l'extrémité dudit au moins un fil parmi la pluralité de fils conducteurs de grille (5) se font face,
et ledit au moins un fil parmi la pluralité de fils conducteurs d'électrode tactile (6) est agencé pour être séparé d'un point de connexion entre ledit au moins un fil parmi la pluralité de fils conducteurs de grille (5) et la ligne de grille correspondante (1) par un distance, de sorte que ledit au moins un fil parmi la pluralité de fils conducteurs d'électrode tactile (6) et ledit au moins un fil parmi la pluralité de fils conducteurs de grille (5) sont isolés l'un de l'autre,
dans lequel le IC de grille (2) est situé d'un côté de la pluralité de lignes de données (4) et le IC tactile est situé d'un autre côté de la pluralité de lignes de données (4),
ledit au moins un fil parmi la pluralité de fils conducteurs d'électrode tactile (6) est séparé du point de connexion entre ledit au moins un fil parmi la pluralité de fils conducteurs de grille (5) et la ligne de grille correspondante (1) le long de la direction dans laquelle une des lignes parmi la pluralité de lignes de données (4) est alignée.

9. Procédé selon la revendication 8, comprenant en outre l'étape consistant à :
former une couche isolante de grille (42) entre la couche conductrice de grille et la couche conductrice de données.

10. Procédé selon la revendication 9, comprenant en outre les étapes consistant à :
former une couche d'électrode tactile (48), la couche d'électrode tactile (48) comprenant une pluralité d'électrodes tactiles (9) ; et
former une couche de planarisation (47) entre la couche d'électrode tactile (48) et la couche conductrice de données.
